# EUROPÄISCHE PATENTSCHRIFT

(11) **EP 3 315 988 B1**
(45) Veröffentlichungstag und Bekanntmachung des Hinweises auf die Patenterteilung: **06.03.2019**
(21) Anmeldenummer: 17196312.7
(22) Anmeldetag: 13.10.2017
(51) Int. Cl.: G01R 33/34, G01R 33/36

(54) **HF-RESONATOR-ANORDNUNG**
HF RESONATOR ARRANGEMENT
ENSEMBLE RÉSONATEUR HF

(30) Priorität: 27.10.2016 DE 102016221161
(43) Veröffentlichungstag der Anmeldung: 02.05.2018
(73) Patentinhaber: Bruker BioSpin AG, 8117 Fällanden (CH)
(72) Erfinder: FREYTAG, Nicolas, 8122 Binz (CH)
(74) Vertreter: Kohler Schmid Möbus Patentanwälte

(56) Entgegenhaltungen:
- DE-A1- 10 118 835

## Beschreibung

Die vorliegende Erfindung betrifft eine HF-Resonator-Anordnung zur Erzeugung mindestens zweier unabhängiger magnetischer Wechselfelder in einem entlang einer Längsachse ausgedehnten Untersuchungsvolumen eines Magnetresonanzgeräts. Unter weiteren Aspekten betrifft die Erfindung eine Messsonde mit der HF-Resonator-Anordnung und ein Magnetresonanzgerät mit der HF-Resonator-Anordnung.

Eine derartige HF-Resonator-Anordnung ist aus der Druckschrift DE 10118835 A1 bekannt.

### Hintergrund der Erfindung

NMR-Spektroskopie (NMR steht für Nuclear Magnetic Resonance, Kernspinresonanz) ist ein Verfahren der instrumentellen Analytik, mit dem insbesondere die chemische Zusammensetzung von Proben bestimmt werden kann. Dabei werden Hochfrequenz(HF)-Pulse in die Probe, die sich in einem starken, homogenen statischen Magnetfeld *B*₀ befindet, eingestrahlt, und die elektromagnetische Reaktion der Probe wird vermessen.

Das Einstrahlen der Hochfrequenz-Pulse und das Empfangen der ebenfalls im Hochfrequenz-Bereich liegenden Reaktion erfolgt durch eine Messsonde. In der Regel werden Messsonden in supraleitenden Magnetsystemen eingesetzt, bei denen das homogene statische Magnetfeld *B*₀ entlang einer "Bohrung" orientiert ist.

Die zu analysierenden Proben, bestehend aus flüssigen, pulverförmigen, gelartigen Substanzen, aber auch Gewebeproben, Einkristallen, Gläsern oder Mischungen verschiedener Stoffe, werden in der Regel in zylinderförmige, insbesondere Kreiszylinderförmige, Behälter gefüllt. Dieser Probenbehälter wird in eine für die Probenaufnahme vorgesehene Aussparung in der Messsonde eingeführt. Um diese Aussparung in der Messsonde herum sind HF-Sende/Empfangs-Anordnungen in der Form von HF-Spulen oder HF-Resonatoren angeordnet, die, wenn sie mit HF-Signalen beaufschlagt werden, elektromagnetische Wechselfelder in der Aussparung und damit in der eingeführten Probe erzeugen. Die elektromagnetischen Wechselfelder, welche die Kernspins in der Probe als Reaktion auf die Anregung aussenden, werden wiederum durch Elemente der HF-Sende/Empfangs-Anordnung empfangen. Das Untersuchungsvolumen des Magnetresonanzgeräts ist durch die Schnittmenge des Volumens mit homogenem statischem Magnetfeld *B*₀, das Probenvolumen und das Volumen, in dem die magnetischen Wechselfelder der HF-Anordnung ausreichend stark sind, definiert.

Es ist üblich, innerhalb eines NMR-Experiments dieselbe HF-Spule resp. denselben HF-Resonator einmal zum Anregen der Kernspins, also als Sendespule resp. Senderesonator, einzusetzen und in einer späteren Phase des NMR-Experiments zur Detektion von Signalen, also als Empfangsspule resp. Empfangsresonator einzusetzen. Dabei werden die entsprechenden HF-Pfade des NMR-Spektrometers entsprechend von einen HF-Sender auf einen Vorverstärker und HF-Empfänger umgeschaltet. Entsprechende Umschaltvorrichtungen sind bekannt. Ein HF-Resonator, der dazu geeignet ist ein magnetisches Wechselfeld in einem Untersuchungsvolumen zu erzeugen, ist gemäß dem bekannten Reziprozitätsprinzip auch dazu geeignet, magnetische Wechselfelder aus dem Untersuchungsvolumen zu empfangen. Ebenso ist ein HF-Resonator, der dazu geeignet ist ein elektrisches Wechselfeld in einem Untersuchungsvolumen zu erzeugen auch dazu geeignet elektrische Wechselfelder zu empfangen.

Aufgrund der extrem kleinen Signale, die bei NMR-Experimenten gemessen werden müssen, hat oft die Empfindlichkeit in der Detektionsphase ein besonders hohes Gewicht beim Design einer Spulenanordnung. In der Regel hat eine NMR-Messsonde eine, eventuell auch zwei bevorzugte Messfrequenzen, die zur Detektion eingesetzt werden. Weitere Messfrequenzen werden hauptsächlich zum Senden von Entkopplungspulsen und für Polarisationstransfers verwendet.

Besonders hohe Empfindlichkeit beim Empfangen von Signalen bieten HF-Resonatoren, die auf die NMR-Resonanzfrequenz des zu messenden Kernspins (beispielsweise der Kernarten ¹H, ¹³C, ¹⁵N, ²H, ¹⁹F) abgestimmt sind. Generell ist es günstig für die Empfindlichkeit, wenn der HF-Resonator möglichst nahe an der Probe angeordnet ist. Wenn nun zwei verschiedene Kernarten, die verschiedene NMR-Resonanzfrequenzen besitzen, z.B. ¹H und ¹³C, oder ¹H und ¹⁹F, beide mit möglichst hoher Empfindlichkeit untersucht werden sollen, braucht es geeignete geometrische Anordnungen der HF-Resonatoren.

### Begriffe

Im Folgenden wird für wichtige Begriffe definiert, wie sie der vorliegenden Beschreibung und in den Ansprüchen verwendet werden.

Unter einer *Spule* verstehen wir einen durchgehenden elektrischen Leiter oder eine resonante Struktur mit Leiterabschnitten und kapazitiven wirkenden Abschnitten und Bauelementen, die in mindestens einer Windung um ein Gebiet herum angeordnet ist.

Unter einer *Flachspule* verstehen wir eine Spule, deren Leiter oder Leiterabschnitte einer ebenen Fläche entlang angeordnet sind. Eine oder mehrere Windungen der Spule umgeben dabei ein Gebiet auf der ebenen Fläche, im Folgenden auch "ebener Flächenabschnitt" genannt. Dieses Gebiet kann beispielsweise die Form eines Rechtecks oder eines beliebigen Vielecks, evtl. mit abgerundeten Ecken, haben. Zur Festlegung einer Lage oder einer Abmessung der Spule ist im Fall von breiten Leiterbahnen oder im Fall von mehreren Windungen der Stromschwerpunkt auf einer Leiterbahn oder der Stromschwerpunkt von benachbarten Leiterelementen mehrerer Windungen in Betracht zu ziehen.

Unter der *Achse einer Spule* verstehen wir eine Achse durch das Gebiet, um welche die Windungen der Spule angeordnet sind und bezüglich der ein Windungssinn der Spule definiert ist. Ein von der stromdurchflossenen Spule erzeugtes Magnetfeld ist im Zentrum der Spule ungefähr entlang der Achsenrichtung der Achse der Spule orientiert.

Unter einer Platte, verstehen wir ein ebenes Bauteil, das in zwei Richtungen parallel zu einer Ebene stärker ausgedehnt ist als in einer dritten, zur Ebene senkrechten Richtung. Unter einer Stirnfläche einer Platte verstehen wir eine die Platte begrenzende, im Wesentlichen parallel zur Ebene verlaufende Fläche. Unter einer Randfläche einer Platte verstehen wir eine die Platte begrenzende Fläche, die keine Stirnfläche ist.

### Stand der Technik

Die Druckschrift DE 10118835 A1 offenbart in Fig. 25 eine HF-Resonator-Anordnung zur Erzeugung zweier unabhängiger magnetischer Wechselfelder in einem Untersuchungsvolumen. Das Untersuchungsvolumen ist durch ein zylindrisches Probenröhrchen begrenzt, also entlang einer zentralen Längsachse ausgedehnt. Die HF-Resonator-Anordnung umfasst einen ersten und einen zweiten Resonator, die beide nahe am Untersuchungsvolumen angeordnet sind. Diese HF-Resonator-Anordnung umfasst ein erstes Paar von zu einem ersten HF-Resonator verschalteten Flachspulen. Diese Flachspulen sind auf zueinander und zur Längsachse parallelen ersten Spulenträgerplatten angeordnet. Diese ersten Spulenträgerplatten liegen auf gegenüberliegenden Seiten des Untersuchungsvolumens. Die HF-Resonator-Anordnung umfasst weiter ein zweites Paar von zu einem zweiten HF-Resonator verschalteten Flachspulen auf zueinander und zur Längsachse parallelen zweiten Spulenträgerplatten. Die zweiten Spulenträgerplatten stehen senkrecht zu den ersten Spulenträgerplatten und sind ebenfalls auf gegenüberliegenden Seiten des Untersuchungsvolumens angeordnet. Jeweils eine Stirnfläche einer Spulenträgerplatte, d.h. eine zur Spulenachse der jeweiligen Flachspule senkrecht stehende Fläche, ist einer Randfläche einer benachbarten Spulenträgerplatte zugewandt. Auf diese Weise definieren die vier Spulenträgerplatten einen das Untersuchungsvolumen umgebenden Raum in Form eines Prismas mit quadratischer oder rechteckiger Grundfläche. Die Spulenträgerplatten ragen - jede in eine andere Richtung - über diese Grundfläche hinaus. Die Druckschrift DE 10118835 A1 lehrt, die Flachspulen auf den Spulenträgerplatten so anzuordnen, dass eine Gruppe von parallel zur Längsachse verlaufende Leiterstrukturen möglichst nahe am Untersuchungsvolumen angeordnet sind. Damit entsteht eine Anordnung, in der die zu einem HF-Resonator gehörenden Flachspulen senkrecht zu ihren Spulenträgerplatten betrachtet, je auf einer Seite der Längsachse angeordnet sind.

Diese aus dem Dokument DE 10118835 A1 bekannte HF-Resonator-Anordnung bringt Leiterstrukturen von zwei unabhängigen HF-Resonatoren sehr dicht ans Untersuchungsvolumen heran.

Typische NMR-Experimente, z.B. für die Untersuchung von Biomolekülen, verwenden sogenannte Triple-Resonanz-Experimente, bei denen auf drei unterschiedlichen Frequenzen (z.B. den Resonanzfrequenzen der in Biomolekülen wichtigen Kerne ¹H, ¹³C, ¹⁵N) gearbeitet wird. Weiter ist es üblich, während der Messungen eine Kernsorte (z.B. ²H) und einen zugehörigen HF-Kanal allein für das Überwachen und das konstant Halten (den sogenannten Lock-Regelkreis) des statischen Magnetfelds B₀ zur Verfügung zu stellen. Weiter werden üblicherweise Gradientenspulen zum gepulsten Anwenden von Magnetfeldgradienten im Untersuchungsvolumen verwendet. Alle diese weiteren Elemente müssen in der Nähe des Untersuchungsvolumens angebracht werden und stehen diesbezüglich in Konkurrenz zueinander. Kompakte Bauweise eines Teils der HF-Resonator-Anordnung steht oft im Widerspruch zu anderen wünschenswerten Eigenschaften der restlichen HF-Resonatoranordnung, wie z.B. hoher Empfindlichkeit, geringer Kopplung zwischen den unterschiedlichen HF-Kanälen oder Homogenität des erzeugten magnetischen Wechselfelds im Untersuchungsvolumen.

### Aufgabe der Erfindung

Es wäre wünschenswert, weitere HF-Resonatoren in einer NMR-Messsonde unterzubringen.

Die Aufgabe der vorliegenden Erfindung besteht demgegenüber darin, möglichst kostengünstig und mit geringem technischen Aufwand eine HF-Resonator-Anordnung mit den eingangs definierten Merkmalen zur Erzeugung mindestens zweier unabhängiger magnetischer Wechselfelder in einem Untersuchungsvolumen eines Magnetresonanzgeräts zur Verfügung zu stellen, die mindestens einen der oben genannten Nachteile des Stands der Technik überwindet.

### Kurze Beschreibung der Erfindung

Diese Aufgabe wird durch die HF-Resonator-Anordnung gemäß Anspruch 1 gelöst.

Die erfindungsgemäße HF-Resonator-Anordnung dient der Erzeugung mindestens zweier unabhängiger magnetischer Wechselfelder in einem Untersuchungsvolumen eines Magnetresonanzgeräts. Die erfindungsgemäße HF-Resonator-Anordnung umfasst
- ein erstes Paar von zu einem ersten HF-Resonator verschalteten Flachspulen mit elektrischen Leiterabschnitten, die zwischen sich jeweils einen ebenen Flächenabschnitt umranden, wobei die Flachspulen auf zueinander und zur Längsachse parallelen ersten Spulenträgerplatten auf gegenüberliegenden Seiten des Untersuchungsvolumens angeordnet sind,
- ein zweites Paar von zu einem zweiten HF-Resonator verschalteten Flachspulen mit elektrischen Leiterabschnitten, die zwischen sich jeweils einen ebenen Flächenabschnitt umranden, wobei die Flachspulen auf zueinander und zur Längsachse parallelen, senkrecht zu den ersten Spulenträgerplatten stehenden, zweiten Spulenträgerplatten auf gegenüberliegenden Seiten des Untersuchungsvolumens angeordnet sind,
- wobei jeweils eine Stirnfläche einer Spulenträgerplatte einer Randfläche einer benachbarten Spulenträgerplatte zugewandt ist.

Erfindungsgemäß überlappen die Projektionen der ebenen Flächenabschnitte des ersten Paars von Flachspulen in einer Richtung senkrecht zu diesen ebenen Flächenabschnitten betrachtet teilweise, aber nicht vollständig und es überlappen die Projektionen der ebenen Flächenabschnitte des zweiten Paars von Flachspulen in einer Richtung senkrecht zu diesen ebenen Flächenabschnitten betrachtet ebenfalls teilweise, aber nicht vollständig.

Dass die Flachspulen lediglich teilweise überlappen ist so zu verstehen, dass das von einer der beteiligten Flachspulen umgebene Gebiet zu einem Teil mit dem von der jeweils anderen Flachspule umgebenen Gebiet überlappt und dass jede der beteiligten Flachspulen auch einen nicht mit der anderen Flachspule überlappenden Teil des umgebenen Gebiets aufweist. Für das Überlappen ist es ausreichend, dass sich die von der Linie der Stromschwerpunkte umgebenen Gebiete überlappen.

Diese HF-Resonator-Anordnung führt überraschenderweise zu höherer Empfindlichkeit auf den Resonanzfrequenzen des ersten und zweiten HF-Resonators, im Vergleich zu der aus dem Stand der Technik bekannten Anordnung. Weiter ist die Homogenität des durch den ersten und zweiten HF-Resonator im Untersuchungsvolumen erzeugten magnetischen Wechselfelds erhöht. Dies hat den Vorteil, die Kernspins im ganzen Untersuchungsvolumen weitgehend dieselbe Auslenkung erfahren, wenn HF-Pulse via die HF-Resonatoren angewendet werden. Betrachtet man die von einem HF-Resonator auf einem Umfang eines Kreises um die Längsachse erzeugten Magnetfeldstärken in Funktion der Position auf dem Umfang, so erkennt man eine Reduktion der Abweichung der Feldstärken von ihrem Mittelwert im Vergleich zum Stand der Technik.

Ein weiterer, für den Fachmann überraschender, Vorteil der erfindungsgemäßen HF-Resonator-Anordnung besteht darin, dass bei Verwendung eines der HF-Resonatoren, z.B. abgestimmt auf die ¹H-Resonanzfrequenz, zur Lösungsmittelunterdrückung mittels Vorsättigung in NMR-Experimenten eine besonders effiziente Unterdrückung der Lösungsmittel-Spektrallinien ermöglicht wird. Der Erfinder hat erkannt, dass die von HF-Resonatoren in der erfindungsgemäßen Anordnung erzeugte Magnetfeldverteilung an den Rändern des Untersuchungsvolumens je eine steil in Richtung der Längsachse abfallende Flanke in der Magnetfeldstärke hat. Im durch die Flanke in der Magnetfeldstärke definierten Übergangsbereich ist die Unterdrückungswirkung des Vorsättigungspulses nicht mehr in vollem Maße vorhanden, während noch eine Restempfindlichkeit auf verbleibende Lösungsmittelsignale vorhanden ist. Ein mit einer steil abfallenden Flanke einhergehender Übergangsbereich mit kleinem Volumen ist daher von Vorteil.

### Bevorzugte Ausführungsformen der Erfindung

In einer Ausführungsform der HF-Resonator-Anordnung sind die Flachspulen aus Leiterstrukturen aufgebaut mit zur Längsachse parallel laufenden Längs-Leiterelementen und quer zur Längsachse stehenden Quer-Leiterelementen, die ein von Leiterstrukturen freies Fenster umranden.

Diese Ausführungsform ist eine besonders einfache und wirksame Form von Flachspulen. Mit den im Betrieb stromdurchflossenen Längs-Leiterelementen wird sehr effizient ein magnetisches Wechselfeld in zu der Längsachse senkrechter Richtung erzeugt. Im Sendefall ist nur die Komponente der magnetischen Wechselfelder senkrecht zum statischen Magnetfeld wirksam. In der üblichen Anordnung liegt die Längsachse des Untersuchungsvolumens parallel zum statischen Magnetfeld einer Magnetresonanzgeräts. Mit den Quer-Leiterelemente kann der Stromkreis im Randbereich des Untersuchungsvolumens geschlossen werden. Der Überlapp der Flachspulen kann in dieser Ausführungsform beispielsweise so groß sein, dass die von Leiterstrukturen freien Fenster überlappen.

In einer Ausführungsform der HF-Resonator-Anordnung sind die Flachspulen aus einem Metall, insbesondere aus Kupfer, Silber oder Aluminium, aus einer Metalllegierung oder aus einem Hochtemperatursupraleiter, insbesondere aus einem Selten-Erde-Barium-Kuprat, gebildet. Die Verwendung von Metallen mit hoher Leitfähigkeit oder von einem Hochtemperatursupraleiter führt zu hohen Resonator-Güten und damit zu hoher Empfindlichkeit beim Empfang von Signalen aus dem Untersuchungsvolumen. Als Hochtemperatursupraleiter kommt beispielsweise Yttrium-Barium-Kuprat (YBCO) in Frage.

In einer Ausführungsform der HF-Resonator-Anordnung umfassen Spulenträgerplatten eines der folgenden Materialien: Glas, Quarz, ein Fluoropolymer, insbesondere Polytetrafluorethylen, eine Keramik, insbesondere Magnesiumoxid oder Bornitrid, Saphir, insbesondere Saphir mit einer Oberfläche parallel zu einer Kristallebene, insbesondere der R-Ebene. In dieser Ausführungsform wird der dielektrische Verlust der HF-Resonatoren minimal gehalten, was zu hoher Empfindlichkeit beim Empfangen von Signalen beiträgt. Saphir mit einer Oberfläche parallel zur R-Kristallebene (englisch: "R-plane") ist besonders geeignet zum epitaktischen Aufwachsen einer Leiterschicht, insbesondere einer YBCO-Schicht.

In einer Ausführungsform der HF-Resonator-Anordnung sind Flachspulen aus Leiterstrukturen mit von Kapazitäten überbrückten Unterbrechungen aufgebaut, wobei die Kapazitäten insbesondere durch parallel zueinander verlaufend Leiterstrukturen und/oder durch verzweigte, fingerförmig ineinandergreifende Leiterstrukturen und/oder durch auf gegenüberliegenden Seiten einer Spulenträgerplatte liegende, überlappende Leiterstrukturen gebildet sind. In dieser Ausführungsform ist zumindest ein Teil der Flachspulen für sich genommen bereits als resonante Struktur ausgebildet, die dann aber erst durch das Verschalten mit der jeweils anderen Flachspule des Paars den ersten resp. zweiten HF-Resonator mit der gewünschten definitiven Resonanzfrequenz bildet. In dieser Ausführungsform können vorgegebene Resonanzfrequenzen des ersten und des zweiten HF-Resonators in einem großen Wertebereich weitgehend unabhängig von den äußeren Abmessungen der Flachspulen erreicht werden, indem die verteilten Kapazitäten und Windungszahlen der Flachspulen geeignet festgelegt werden. Insbesondere ist die Positionierung der Kapazitäten frei wählbar und kann sowohl symmetrisch als auch asymmetrisch erfolgen.

In einer Ausführungsform der HF-Resonator-Anordnung die ist Verschaltung zu einem HF-Resonator durch galvanische Verbindung und/oder transformatorische Kopplung der Flachspulen vermittelt.

Eine Ausführungsform der HF-Resonator-Anordnung umfasst mindestens ein weiteres Paar von zu einem weiteren HF-Resonator verschalteten Flachspulen auf zueinander und zur Längsachse parallelen weiteren Spulenträgerplatten auf gegenüberliegenden Seiten der ersten Spulenträgerplatten. In dieser Ausführungsform zeigt sich der Vorteil der teilweise überlappenden Flachspulen des ersten und zweiten HF-Resonators darin, dass bei vorgegebenen Spulenabmessungen weitere, bezüglich des Untersuchungsvolumens weiter außen als die ersten Spulenträgerplatten liegende Flachspulen, näher am Untersuchungsvolumen angebracht werden können, als im Fall von nicht überlappenden Flachspulen. D.h. die Empfindlichkeit des ersten und zweiten Resonators wird nicht auf Kosten des weiteren Resonators erhöht. Im Gegenteil, die Empfindlichkeit des weiteren Resonators kann durch eine näher am Untersuchungsvolumen liegende Position ebenfalls weiter erhöht sein.

In einer Ausführungsform der HF-Resonator-Anordnung überlappen sich die Flachspulen des weiteren Paars, senkrecht zu den Stirnflächen der weiteren Spulenträgerplatten betrachtet, vollständig oder teilweise. Für die Anordnung des Paars von Flachspulen des weiteren Resonators besteht die Möglichkeit, vollständiger Überlappung in Richtung der Spulenachsen gesehen, was einer sogenannten Helmholtz-Anordnung entspricht. In dieser Anordnung kann die Homogenität des vom weiteren HF-Resonator erzeugten magnetischen Wechselfelds im Untersuchungsvolumen maximiert werden. Alternativ kann teilweise Überlappung der Flachspulen und eine versetzte Anordnung der weiteren Spulenträgerplatten gewählt werden, was besonders günstig ist, wenn noch ein weiteres (viertes) Paar von Flachspulen möglichst nahe am Untersuchungsvolumen angebracht werden soll.

Eine weitere Ausführungsform der HF-Resonator-Anordnung umfasst ein drittes Paar von zu einem dritten HF-Resonator verschalteten Flachspulen auf zueinander und zur Längsachse parallelen dritten Spulenträgerplatten und ein viertes Paar von zu einem vierten HF-Resonator verschalteten Flachspulen auf zueinander und zur Längsachse parallelen vierten Spulenträgerplatten, wobei der erste HF-Resonator sowohl vom zweiten HF-Resonator als auch vom vierten HF-Resonator induktiv entkoppelt ist und wobei der dritte HF-Resonator sowohl vom zweiten HF-Resonator als auch vom vierten HF-Resonator induktiv entkoppelt ist.

Überraschenderweise brauchen die von den HF-Resonatoren erzeugten Felder im Messvolumen nicht orthogonal zueinander zu stehen, um eine induktive Entkopplung der HF-Resonatoren zu erreichen. So ist gemäß dieser Ausführungsform jeder HF-Resonator aus einer den ersten und dritten HF-Resonator umfassenden Gruppe von jedem HF-Resonator aus einer den zweiten und vierten HF-Resonator umfassenden Gruppe induktiv entkoppelt.

In einer Ausführungsform der HF-Resonator-Anordnung sind die dritten Spulenträgerplatten parallel zu den ersten Spulenträgerplatten angeordnet und sind die vierten Spulenträgerplatten parallel zu den zweiten Spulenträgerplatten angeordnet. In dieser Anordnung ist die wechselseitige induktive Entkopplung bei fast allen Paarkombinationen (bis auf erster mit drittem und zweiter mit viertem Resonator) aus erstem bis viertem Resonator bereits durch die Symmetrie der Anordnung verwirklicht.

In einem weiteren Aspekt bezieht sich die Erfindung auf eine Messsonde mit einer erfindungsgemäßen HF-Resonator-Anordnung. Bei dieser erfindungsgemäßen Messsonde ist ein erster HF-Eingang über ein erstes Abstimmnetzwerk hochfrequenzmäßig an den ersten HF-Resonator angekoppelt und es ist ein zweiter HF-Eingang über ein zweites Abstimmnetzwerk hochfrequenzmäßig an den zweiten HF-Resonator angekoppelt. Eine solche Messsonde, z.B. ein NMR-Probenkopf stellt die erfindungsgemäße HF-Resonator-Anordnung in einer für den Benutzer direkt einsetzbaren Form zur Verfügung. Das Abstimmnetzwerk kann über induktive oder kapazitive Kopplungselemente mit den HF-Resonatoren verbunden sein. Insbesondere ist eine transformatorische Ankopplung an das jeweilige Paar von Flachspulen denkbar, wobei eine HF-technische Verbindung zum Spulenpaar durch induktiv gekoppelte Spulen erreicht wird und wobei auf Seiten des HF-Resonators eine oder beide Flachspulen, oder alternativ eine zusätzliche, mit den HF-Resonatoren in Serie geschaltete, Spule als Kopplungspartner zum Abstimmnetzwerk dienen können. Das Abstimmnetzwerk kann verstellbare Elemente, beispielsweise Trimmer, aufweisen, mit denen die unter anderem auch von der ins Untersuchungsvolumen eingeführten Probe abhängigen Resonanzfrequenzen des ersten und zweiten HF-Resonators nachjustiert werden können. Ebenso können justierbare induktiv gekoppelte Elemente vorgesehen sein um die Resonanzfrequenz oder die Impedanz anzupassen. Die HF-Eingänge können beispielsweise Anschlüsse für Koaxialkabel sein.

In einem weiteren Aspekt bezieht sich die Erfindung auf ein Magnetresonanzgerät mit einer erfindungsgemäßen HF-Resonator-Anordnung oder mit einer erfindungsgemäßen Messsonde. Die HF-Resonator-Anordnung kann fest ins Magnetresonanzgerät eingebaut sein. Das Magnetresonanzgerät kann beispielsweise eine Vorrichtung zur Erzeugung eines statischen Magnetfelds mit einer Magnetfeldrichtung parallel zur Längsachse des Untersuchungsvolumens haben.

In einer Ausführungsform des Magnetresonanzgeräts sind der erste HF-Resonator und der zweite HF-Resonator je mit einer ersten und einer zweiten HF-Sendeeinheit gesteuert wirkverbunden. In dieser Ausführungsform können durch geeignete Ansteuerung der Wirkverbindung zwischen der jeweiligen HF-Sendeeinheiten und dem entsprechenden HF-Resonator zeitlich gepulste magnetische Wechselfelder im Untersuchungsvolumen des Magnetresonanzgeräts, und damit in einer im Untersuchungsvolumen befindlichen Probe, hervorgerufen werden.

Detaillierte Beschreibung der Erfindung und Zeichnung Ausführungsbeispiele der vorliegenden Erfindung werden nachstehend anhand von Figuren noch näher erläutert.

Es zeigen:

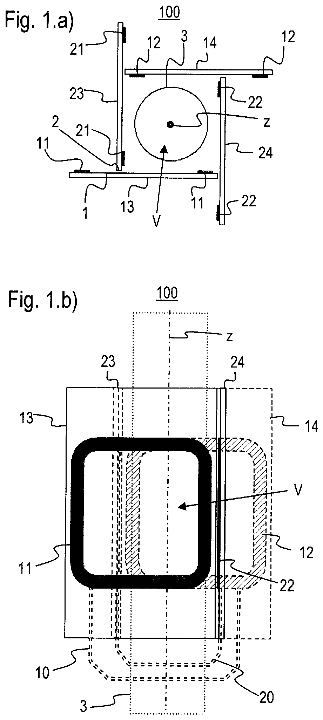

Fig. 1.a) eine Querschnitt durch eine erfindungsgemäße HF-Resonator-Anordnung;
Fig. 1.b) eine Aufsicht auf eine erfindungsgemäßen HF-Resonator-Anordnung;
Fig. 2. Eine Flachspule gemäß einer Ausführungsform;
Fig. 3. Einen Querschnitt durch eine Ausführungsform der HF-Resonator-Anordnung;
Fig. 4.a) und Fig. 4.b) Querschnitte durch weitere Ausführungsformen der HF-Resonator-Anordnung;
Fig. 5.a) einen Querschnitt durch und 5.b) eine Aufsicht auf eine HF-Resonator-Anordnung gemäß Stand der Technik.

In Figur 1.a) ist ein senkrecht zu einer zentralen Längsachse z verlaufender Querschnitt durch eine erfindungsgemäße HF-Resonator-Anordnung gezeigt. Spulenträgerplatten 13, 14, 23, 24 sind um ein Untersuchungsvolumen V herum angeordnet. Jede der Spulenplatten ist mit einer Stirnfläche 1 einer Randfläche 2 einer benachbarten Spulenträgerplatte zugewandt. Der Übersicht halber sind die einander zugewandte Stirnfläche 1 und Randfläche 2 nur für die benachbarten Spulenträgerplatten 13 und 23 mit Bezugszeichen versehen. Erste Spulenträgerplatten 13, 14 liegen parallel zur Längsachse z und parallel zueinander jeweils auf gegenüberliegenden Seiten des Untersuchungsvolumens. Senkrecht zu den ersten Spulenträgerplatten stehen zweite Spulenträgerplatten 23, 24. Die zweiten Spulenträgerplatten 23, 24 liegen ebenfalls parallel zur Längsachse z und parallel zueinander jeweils auf gegenüberliegenden Seiten des Untersuchungsvolumens. Auf jeder Spulenträgerplatte ist eine Flachspule 11, 12, 21, 22 angeordnet. Der gezeigte Querschnitt verläuft durch parallel zur Längsachse verlaufende Längs-Leiterelemente der Flachspulen.

Figur 1.b) zeigt die Aufsicht auf die erfindungsgemäße HF-Resonator-Anordnung. Die Blickrichtung in dieser Ansicht liegt senkrecht zu den Stirnflächen der ersten Spulenträgerplatten 13 und 14. Der teilweise Überlapp der Flachspulen 11 und 12 ist in dieser Ansicht erkennbar. In diesem Fall entspricht der Überlapp gerade der Projektion des Untersuchungsvolumens in der Blickrichtung. Die Flachspule 11 und die Flachspule 12 sind zu einem ersten HF-Resonator 10 verschaltet, wie durch die gestrichelte Doppellinie schematisch angedeutet. Ebenso sind die Flachspule 21 und die Flachspule 22 zu einem zweiten HF-Resonator 20 verschaltet. Der Raum 3 zur Aufnahme einer Probe hat hier die Form eines Kreiszylinders mit einer Zylinderachse, die mit der Längsachse z zusammenfällt und ist in Längsrichtung über die Flachspulen hinaus ausgedehnt. Der Raum 3 zur Aufnahme einer Probe kann durch eine Wandung begrenzt sein, z.B. um unterschiedliche Temperierung von HF-Resonator-Anordnung und Probe zu ermöglichen, er kann aber auch durch eine Probenhalterung und die Probenbehältergeometrie definiert sein.

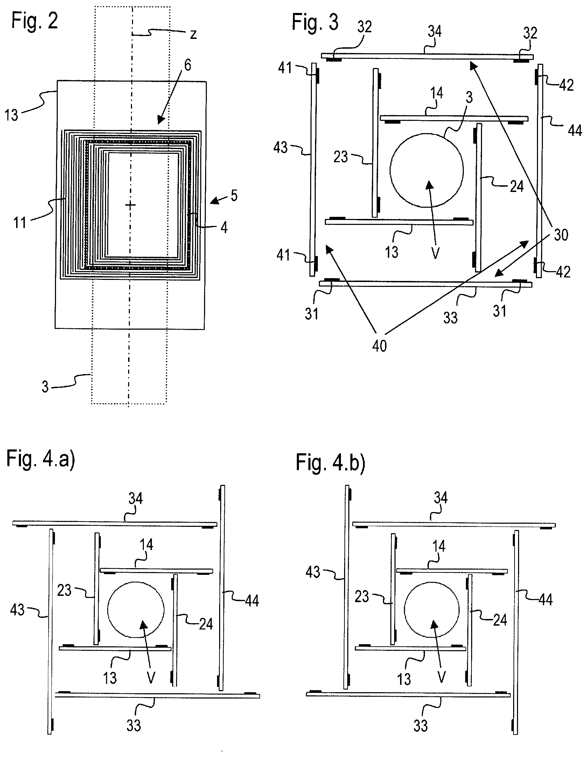

In Figur 2 ist die Flachspule 11 gemäß einer Ausführungsform gezeigt. Die Flachspule ist aus Leiterstrukturen aufgebaut, die auf der Spulenträgerplatte 13 angebracht sind. Die Spule hat mehrere Windungen. Ein Spulenfenster 4 ist entsprechend der Lage der Stromschwerpunkte eingezeichnet. Längs-Leiterelemente 5 und Quer-Leiterelemente 6 umranden ein rechteckiges Gebiet, das keine Leiterstrukturen aufweist. Hier greifen die Längs-Leiterelemente links der Längsachse z fingerförmig ineinander, wodurch Kapazitäten gebildet werden, welche Unterbrechungen zwischen den Leiterstrukturen hochfrequenzmäßig überbrücken. In hier gezeigten Fall überdeckt das Spulenfenster den Raum 3 zur Aufnahme einer Probe. Das Spulenfenster liegt asymmetrisch zur Längsachse, sodass mit einer (nicht eingezeichneten), um 180° bezüglich der Längsachse gedrehten Flachspule gleicher Form ein teilweiser Überlapp entstehen würde.

In Figur 3 ist ein Querschnitt durch eine Ausführungsform der HF-Anordnung gezeigt, welche zusätzlich zum ersten und zum zweiten HF-Resonator einen dritten 30 und einen vierten 40 HF-Resonator aufweist. Dazu sind dritte Flachspulen 31, 32 auf dritten Spulenträgerplatten 33, 34 angeordnet und es sind vierte Flachspulen 41, 42 auf vierten Spulenträgerplatten 43, 44 angeordnet. In der hier gezeigten Anordnung überlappen die dritten und vierten Flachspulen in Richtung senkrecht zu den Stirnflächen ihrer Spulenträgerplatten gesehen jeweils vollständig, d.h. sind in sogenannter Helmholtz-Anordnung positioniert. Die HF-Resonatoren 10 und 30 können induktiv von den HF-Resonatoren 20 und 40 entkoppelt sein.

In den Figuren 4.a) und 4.b) ist jeweils ein Querschnitt durch weitere Ausführungsformen der HF-Anordnung mit zusätzlichem dritten und vierten HF-Resonator gezeigt. Aus Gründen der Übersichtlichkeit sind hier nur noch die Spulenträgerplatten mit Bezugszeichen versehen. In diesen beiden Ausführungsformen überlappen die dritten und vierten Flachspulen jeweils teilweise, d.h. die in Bezug auf das Untersuchungsvolumen außen liegende Anordnung des dritten und vierten HF-Resonators zueinander gleicht der innen liegenden Anordnung des ersten und zweiten Resonators. Dabei ist der Drehsinn der durch die außen liegende Anordnung gebildeten Rosette im Fall der Fig. 4.a) gegengleich zur inneren Anordnung, im Fall der Fig. 4.b) ist der Drehsinn der beiden Rosetten gleich. Die Gruppe umfassend die HF-Resonatoren 10 und 30 kann von der Gruppe umfassend die HF-Resonatoren 20, 40 sowohl in Fig. 4.a) als auch in Fig. 4.b) induktiv entkoppelt sein.

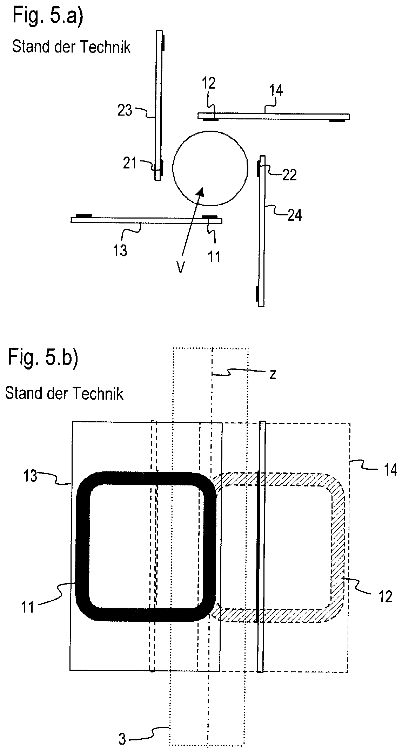

In der Figuren 5.a) ist ein Querschnitt und in Figur 5.b) die dazugehörende Aufsicht auf eine HF-Resonator-Anordnung gemäß dem in der Druckschrift DE 10118835 A1 offenbarten Stand der Technik dargestellt. Die Flachspulen 11 und 12, und ebenso die Flachspulen 21 und 22, überlappen hier nicht. Das rührt daher, dass es gemäß der Lehre der DE 10118835 A1 auf jeder Flachspule Längs-Leiterelemente geben muss, die maximal nahe am Untersuchungsvolumen angeordnet sind.

### Bezugszeichenliste

- 1: Stirnfläche
- 2: Randfläche
- 3: Raum zur Aufnahme einer Probe
- 4: Spulenfenster
- 5: Längs-Leiterelement
- 6: Quer-Leiterelemente
- 10: erster HF-Resonator
- 11, 12: Flachspulen (erstes Paar)
- 13, 14: erste Spulenträgerplatten
- 20: zweiter HF-Resonator
- 21, 22: Flachspulen (zweites Paar)
- 23, 24: zweite Spulenträgerplatten
- 30: dritter HF-Resonator
- 31, 32: Flachspulen (drittes Paar)
- 33, 34: dritte Spulenträgerplatten
- 40: zweiter HF-Resonator
- 41, 42: Flachspulen (viertes Paar)
- 43, 44: vierte Spulenträgerplatten
- 100: HF-Resonator-Anordnung
- V: Untersuchungsvolumen
- z: Längsachse

## Patentansprüche

1. HF-Resonator-Anordnung (100) zur Erzeugung mindestens zweier unabhängiger magnetischer Wechselfelder in einem entlang einer zentralen Längsachse (z) ausgedehnten Untersuchungsvolumen (V) eines Magnetresonanzgeräts, umfassend
- ein erstes Paar von zu einem ersten HF-Resonator (10) verschalteten Flachspulen (11, 12) mit elektrischen Leiterabschnitten, die zwischen sich jeweils einen ebenen Flächenabschnitt umranden, wobei die Flachspulen (11, 12) auf zueinander und zur Längsachse (z) parallelen ersten Spulenträgerplatten (13, 14) auf gegenüberliegenden Seiten des Untersuchungsvolumens (V) angeordnet sind,
- ein zweites Paar von zu einem zweiten HF-Resonator (20) verschalteten Flachspulen (21, 22) mit elektrischen Leiterabschnitten, die zwischen sich jeweils einen ebenen Flächenabschnitt umranden, wobei die Flachspulen (21, 22) auf zueinander und zur Längsachse (z) parallelen, senkrecht zu den ersten Spulenträgerplatten (13, 14) stehenden, zweiten Spulenträgerplatten (23, 24) auf gegenüberliegenden Seiten des Untersuchungsvolumens (V) angeordnet sind,
- wobei jeweils eine Stirnfläche (1) einer Spulenträgerplatte (13) einer Randfläche (2) einer benachbarten Spulenträgerplatte (23) zugewandt ist,
**dadurch gekennzeichnet,**
**dass** die Projektionen der ebenen Flächenabschnitte des ersten Paars von Flachspulen (11, 12) in einer Richtung senkrecht zu diesen ebenen Flächenabschnitten betrachtet teilweise, aber nicht vollständig überlappen,
und **dass** die Projektionen der ebenen Flächenabschnitte des zweiten Paars von Flachspulen (21, 22) in einer Richtung senkrecht zu diesen ebenen Flächenabschnitten betrachtet ebenfalls teilweise, aber nicht vollständig überlappen.

2. HF-Resonator-Anordnung nach Anspruch 1, wobei die Flachspulen (11,12; 21,22; 31,32; 41,42) aus Leiterstrukturen aufgebaut sind mit zur Längsachse (z) parallel laufenden Längs-Leiterelementen (5) und quer zur Längsachse (z) stehenden Quer-Leiterelementen (6), die ein von Leiterstrukturen freies Fenster (4) umranden.

3. HF-Resonator-Anordnung nach einem der Ansprüche 1 oder 2, wobei die Flachspulen (11,12; 21,22; 31,32; 41,42) aus einem Metall, insbesondere aus Kupfer, Silber oder Aluminium, und/oder aus einem Hochtemperatursupraleiter, insbesondere aus einem Selten-Erde-Barium-Kuprat, gebildet sind.

4. HF-Resonator-Anordnung nach einem der Ansprüche 1 bis 3, wobei Spulenträgerplatten (13,14; 23,24; 33,34; 43,44) eines der folgenden Materialien umfassen: Glas, Quarz, ein Fluoropolymer, insbesondere Polytetrafluoräthylen, eine Keramik, insbesondere Magnesiumoxid, Aluminiumoxid oder Bornitrid, Saphir, insbesondere Saphir mit einer Oberfläche parallel zu einer Kristallebene, insbesondere der R-Ebene.

5. HF-Resonator-Anordnung nach einem der Ansprüche 1 bis 4, wobei Flachspulen (11,12; 21,22; 31,32; 41,42) aus Leiterstrukturen mit von Kapazitäten überbrückten Unterbrechungen aufgebaut sind, wobei die Kapazitäten insbesondere durch parallel zueinander verlaufend Leiterstrukturen und/oder durch verzweigte, fingerförmig ineinandergreifende Leiterstrukturen und/oder durch auf gegenüberliegenden Seiten einer Spulenträgerplatte (13,14; 23,24; 33,34; 43,44) liegende, überlappende Leiterstrukturen gebildet sind.

6. HF-Resonator-Anordnung nach einem der Ansprüche 1 bis 5, wobei die Verschaltung zu einem HF-Resonator (10; 20) durch galvanische Verbindung und/oder transformatorische Kopplung der Flachspulen (11,12; 21,22; 31,32; 41,42) vermittelt ist.

7. HF-Resonator-Anordnung nach einem der Ansprüche 1 bis 6, umfassend mindestens ein weiteres Paar von zu einem weiteren HF-Resonator (30) verschalteten Flachspulen (31,32) auf zueinander und zur Längsachse (z) parallelen weiteren Spulenträgerplatten (33,34) auf gegenüberliegenden Seiten der ersten Spulenträgerplatten (13,14).

8. HF-Resonator-Anordnung nach Anspruch 7, wobei sich die Flachspulen (31,32; 41,42) des weiteren Paars, senkrecht zu den Stirnflächen der weiteren Spulenträgerplatten (33,34; 43,44) betrachtet, vollständig überlappen oder teilweise überlappen.

9. HF-Resonator-Anordnung nach einem der Ansprüche 7 oder 8, umfassend ein drittes Paar von zu einem dritten HF-Resonator (30) verschalteten Flachspulen (31, 32) auf zueinander und zur Längsachse (z) parallelen dritten Spulenträgerplatten (33, 34) und ein viertes Paar von zu einem vierten HF-Resonator (40) verschalteten Flachspulen (41, 42) auf zueinander und zur Längsachse (z) parallelen vierten Spulenträgerplatten (43, 44),
wobei der erste HF-Resonator (10) sowohl vom zweiten HF-Resonator (20) als auch vom vierten HF-Resonator (40) induktiv entkoppelt ist und wobei der dritte HF-Resonator (30) sowohl vom zweiten HF-Resonator (20) als auch vom vierten HF-Resonator (40) induktiv entkoppelt ist.

10. HF-Resonator-Anordnung nach Anspruch 9, wobei die dritten Spulenträgerplatten (33, 34) parallel zu den ersten Spulenträgerplatten (13, 14) angeordnet sind und die vierten Spulenträgerplatten (43, 44) parallel zu den zweiten Spulenträgerplatten (23, 24) angeordnet sind.

11. Messsonde mit einer HF-Resonator-Anordnung (100) nach einem der Ansprüche 1 bis 10 und mit mindestens zwei HF-Eingängen, wobei ein erster HF-Eingang über ein erstes Abstimmnetzwerk hochfrequenzmäßig an den ersten HF-Resonator (10) angekoppelt ist und wobei ein zweiter HF-Eingang über ein zweites Abstimmnetzwerk hochfrequenzmäßig an den zweiten HF-Resonator (20) angekoppelt ist.

12. Magnetresonanzgerät mit einer HF-Resonator-Anordnung (100) nach einem der Ansprüche 1 bis 10 oder mit einer Messsonde nach Anspruch 11.

13. Magnetresonanzgerät nach Anspruch 12, wobei der erste HF-Resonator (10) und der zweite HF-Resonator (20) je mit einer ersten und einer zweiten HF-Sendeeinheit gesteuert wirkverbunden sind.

## Claims

1. RF resonator assembly (100) for generating at least two independent alternating magnetic fields in a test volume (V) of a magnetic resonance apparatus, which test volume extends along a central longitudinal axis (z), said resonator assembly comprising
- a first pair of flat coils (11, 12) that are connected to form a first RF resonator (10) and comprise electrical conductor portions that in each case border a planar surface portion therebetween, the flat coils (11, 12) being arranged on opposing sides of the test volume (V), on first coil support plates (13, 14) that are mutually parallel and in parallel with the longitudinal axis (z),
- a second pair of flat coils (21, 22) that are connected to form a second RF resonator (20) and comprise electrical conductor portions that in each case border a planar surface portion therebetween, the flat coils (21, 22) being arranged on opposing sides of the test volume (V), on second coil support plates (23, 24) that are mutually parallel and in parallel with the longitudinal axis (z) and perpendicular to the first coil support plates (13, 14),
- each end face (1) of a coil support plate (13) facing an edge surface (2) of an adjacent coil support plate (23),
**characterized in that**
the projections of the planar surface portions of the first pair of flat coils (11, 12) overlap in part, but not completely, when viewed in a direction perpendicular to said planar surface portions,
and **in that** the projections of the planar surface portions of the second pair of flat coils (21, 22) overlap in part, but not completely, when viewed in a direction perpendicular to said planar surface portions.

2. RF resonator assembly according to claim 1, wherein the flat coils (11, 12; 21, 22; 31, 32; 41, 42) are constructed from conductor structures having longitudinal conductor elements (5) that extend in parallel with the longitudinal axis (z) and transverse conductor elements (6) that are transverse to the longitudinal axis (z), which elements border a window (4) that is free of conductor structures.

3. RF resonator assembly according to either claim 1 or claim 2, wherein the flat coils (11, 12; 21, 22; 31, 32; 41, 42) are made of a metal, in particular copper, silver or aluminum, and/or of a high-temperature superconductor, in particular of a rare-earth barium cuprate.

4. RF resonator assembly according to any of claims 1 to 3, wherein coil support plates (13, 14; 23, 24; 33, 34; 43, 44) comprise one of the following materials: glass, quartz, a fluoropolymer, in particular polytetrafluoroethylene, a ceramic, in particular magnesium oxide, aluminum oxide or boron nitride, sapphire, in particular sapphire having a surface in parallel with a crystal plane, in particular the R-plane.

5. RF resonator assembly according to any of claims 1 to 4, wherein flat coils (11, 12; 21, 22; 31, 32; 41, 42) are constructed from conductor structures having breaks that are bridged by capacitors, wherein the capacitors are formed in particular by conductor structures extending in parallel with one another and/or by branched conductor structures engaging in one another in a finger-like manner and/or by overlapping conductor structures positioned on opposing sides of a coil support plate (13, 14; 23, 24; 33, 34; 43, 44).

6. RF resonator assembly according to any of claims 1 to 5, wherein the connection to form an RF resonator (10; 20) is achieved by galvanic connection and/or transformer coupling of the flat coils (11, 12; 21, 22; 31, 32; 41, 42) .

7. RF resonator assembly according to any of claims 1 to 6, comprising at least one further pair of flat coils (31, 32), which are connected to form a further RF resonator (30), on further coil support plates (33, 34) on opposing sides of the first coil support plates (13, 14), which further coil support plates are mutually parallel and in parallel with the longitudinal axis (z).

8. RF resonator assembly according to claim 7, wherein the flat coils (31, 32; 41, 42) of the further pair overlap completely or in part when viewed perpendicularly to the end faces of the further coil support plates (33, 34; 43, 44) .

9. RF resonator assembly according to either claim 7 or claim 8, comprising a third pair of flat coils (31, 32) that are connected to form a third RF resonator (30) and that are on third coil support plates (33, 34) that are mutually parallel and in parallel with the longitudinal axis (z), and a fourth pair of flat coils (41, 42) that are connected to form a fourth RF resonator (40) and that are on fourth coil support plates (43, 44) that are mutually parallel and in parallel with the longitudinal axis (z), wherein the first RF resonator (10) is inductively decoupled from both the second RF resonator (20) and the fourth RF resonator (40), and wherein the third RF resonator (30) is inductively decoupled from both the second RF resonator (20) and the fourth RF resonator (40).

10. RF resonator assembly according to claim 9, wherein the third coil support plates (33, 34) are arranged in parallel with the first coil support plates (13, 14) and the fourth coil support plates (43, 44) are arranged in parallel with the second coil support plates (23, 24).

11. Measuring probe comprising an RF resonator assembly (100) according to any of claims 1 to 10 and comprising at least two RF inputs, wherein a first RF input is coupled to the first RF resonator (10) at a radio frequency via a first tuning network, and wherein a second RF input is coupled to the second RF resonator (20) at a radio frequency via a second tuning network.

12. Magnetic resonance apparatus comprising an RF resonator assembly (100) according to any of claims 1 to 10 or comprising a measuring probe according to claim 11.

13. Magnetic resonance apparatus according to claim 12, wherein the first RF resonator (10) and the second RF resonator (20) are each operatively connected in a controllable way to a first and a second RF transmitting unit.

## Revendications

1. Agencement de résonateurs HF (100) pour générer au moins deux champs magnétiques alternatifs indépendants dans un volume d'examen (V) étendu le long d'un axe longitudinal central (z) d'un appareil de résonance magnétique, comprenant
- une première paire de bobines plates (11) connectées de manière à former un premier résonateur HF (10) et présentant des sections de conducteurs électriques qui entourent chaque fois une section de surface plane entre elles, les bobines plates (11, 12) étant disposées sur des premières plaques porte-bobines (13, 14) parallèles entre elles et à l'axe longitudinal (z) sur des côtés opposés du volume d'examen (V),
- une deuxième paire de bobines plates (21, 22) connectées de manière à former un deuxième résonateur HF (20) et présentant des sections de conducteurs électriques qui entourent chaque fois une section de surface plane entre elles, les bobines plates (21, 22) étant disposées sur des deuxièmes plaques porte-bobines (23, 24) parallèles entre elles et à l'axe longitudinal (z), perpendiculaires aux premières plaques porte-bobines (13, 14), sur des côtés opposés du volume d'examen (V),
- une surface frontale (1) d'une plaque porte-bobines (13) étant chaque fois tournée vers une surface de bord (2) d'une plaque porte-bobines adjacente (23),
**caractérisé en ce que**
les projections des sections de surface planes de la première paire de bobines plates (11, 12), vues dans une direction perpendiculaire à ces sections de surface planes, se chevauchent partiellement mais pas complètement,
et **en ce que** les projections des sections de surface planes de la deuxième paire de bobines plates (21, 22), vues dans une direction perpendiculaire à ces sections de surface planes, se chevauchent également partiellement mais pas complètement.

2. Agencement de résonateurs HF selon la revendication 1, dans lequel les bobines plates (11, 12 ; 21, 22 ; 31, 32 ; 41, 42) sont constituées de structures conductrices avec des éléments conducteurs longitudinaux (5) s'étendant parallèlement à l'axe longitudinal (z) et des éléments conducteurs transversaux (6) s'étendant transversalement à l'axe longitudinal (z), qui entourent une fenêtre (4) exempte de structures conductrices.

3. Agencement de résonateurs HF selon l'une des revendications 1 ou 2, dans lequel les bobines plates (11, 12 ; 21, 22 ; 31, 32 ; 41, 42) sont formées d'un métal, en particulier de cuivre, d'argent ou d'aluminium, et/ou d'un supraconducteur haute température, en particulier d'un cuprate de baryum et terres rares.

4. Agencement de résonateurs HF selon l'une des revendications 1 à 3, dans lequel les plaques porte-bobines (13, 14 ; 23, 24 ; 33, 34 ; 43, 44) comprennent l'un des matériaux suivants : verre, quartz, un polymère fluoré, en particulier du polytétrafluoroéthylène, une céramique, en particulier de l'oxyde de magnésium, de l'oxyde d'aluminium ou du nitrure de bore, du saphir, en particulier du saphir avec une surface parallèle à un plan cristallin, en particulier le plan R.

5. Agencement de résonateurs HF selon l'une des revendications 1 à 4, dans lequel les bobines plates (11, 12 ; 21, 22; 31, 32 ; 41, 42) sont constituées de structures conductrices avec des interruptions pontées par des capacités, les capacités étant formées en particulier par des structures conductrices s'étendant parallèlement les unes aux autres et/ou par des structures conductrices ramifiées, imbriquées en forme de doigts et/ou par des structures conductrices situées sur des côtés opposés d'une plaque porte-bobines (13, 14 ; 23, 24 ; 33, 34 ; 43, 44) et qui se chevauchent.

6. Agencement de résonateurs HF selon l'une des revendications 1 à 5, dans lequel la connexion pour former un résonateur HF (10 ; 20) est réalisée par liaison galvanique et/ou couplage par transformateur des bobines plates (11, 12 ; 21, 22 ; 31, 32 ; 41, 42).

7. Agencement de résonateurs HF selon l'une des revendications 1 à 6, comprenant au moins une autre paire de bobines plates (31, 32) connectées pour former un autre résonateur HF (30) sur d'autres plaques porte-bobines (33, 34) parallèles entre elles et à l'axe longitudinal (z) sur des côtés opposés des premières plaques porte-bobines (13, 14).

8. Agencement de résonateurs HF selon la revendication 7, dans lequel les bobines plates (31, 32 ; 41, 42) de l'autre paire, vues perpendiculairement aux surfaces frontales des autres plaques porte-bobines (33, 34 ; 43, 44), se chevauchent complètement ou partiellement.

9. Agencement de résonateurs HF selon l'une des revendications 7 ou 8, comprenant une troisième paire de bobines plates (31, 32) connectées pour former un troisième résonateur HF (30) sur des troisièmes plaques porte-bobine (33, 34) parallèles entre elles et à l'axe longitudinal (z) et une quatrième paire de bobines plates (41, 42) connectées pour former un quatrième résonateur HF (40) sur des quatrièmes plaques porte-bobines (43, 44) parallèles entre elles et à l'axe longitudinal (z),
le premier résonateur HF (10) étant découplé inductivement aussi bien du deuxième résonateur HF (20) que du quatrième résonateur HF (40) et le troisième résonateur HF (30) étant découplé inductivement aussi bien du deuxième résonateur HF (20) que du quatrième résonateur HF (40).

10. Agencement de résonateurs HF selon la revendication 9, dans lequel les troisièmes plaques porte-bobines (33, 34) sont disposées parallèlement aux premières plaques porte-bobines (13, 14) et les quatrième plaques porte-bobines (43, 44) sont disposées parallèlement aux deuxièmes plaques porte-bobines (23, 24).

11. Sonde de mesure dotée d'un agencement de résonateurs HF (100) selon l'une des revendications 1 à 10 et au moins deux entrées HF, une première entrée HF étant couplée à haute fréquence au premier résonateur HF (10) via un premier réseau d'accord et une deuxième entrée HF étant couplée à haute fréquence au deuxième résonateur HF (20) via un deuxième réseau d'accord.

12. Appareil de résonance magnétique doté d'un agencement de résonateurs HF (100) selon l'une des revendications 1 à 10 ou d'une sonde selon la revendication 11.

13. Appareil de résonance magnétique selon la revendication 12, dans lequel le premier résonateur HF (10) et le deuxième résonateur HF (20) sont chacun en liaison fonctionnelle commandée avec une première et une deuxième unité d'émission HF.
